# EUROPÄISCHE PATENTSCHRIFT

(11) **EP 1 181 723 B1**
(45) Veröffentlichungstag und Bekanntmachung des Hinweises auf die Patenterteilung: **11.08.2004**
(21) Anmeldenummer: 00949064.0
(22) Anmeldetag: 26.05.2000
(51) Int. Cl.: H01L 29/786, H01L 21/336

(54) **DOPPEL-GATE-MOSFET-TRANSISTOR UND VERFAHREN ZU SEINER HERSTELLUNG**
DOUBLE GATE MOSFET TRANSISTOR AND METHOD FOR THE PRODUCTION THEREOF
TRANSISTOR A EFFET DE CHAMP A PORTEE ISOLEE A GRILLE DOUBLE ET PROCEDE PERMETTANT DE LE PRODUIRE

(30) Priorität: 28.05.1999 DE 19924571
(43) Veröffentlichungstag der Anmeldung: 27.02.2002
(73) Patentinhaber: Infineon Technologies AG, 81669 München (DE)
(72) Erfinder: RÖSNER, Wolfgang, D-81739 München (DE); SCHULZ, Thomas, D-81737 München (DE); RISCH, Lothar, D-85579 Neubiberg (DE)
(74) Vertreter: Graf Lambsdorff, Matthias, Dr.
(86) Internationale Anmeldenummer: PCT/DE2000/001714
(87) Internationale Veröffentlichungsnummer: WO 2000/074143

(56) Entgegenhaltungen:
- EP-A- 0 612 103
- EP-A- 0 704 909
- DE-A- 19 803 479
- US-A- 5 120 666
- US-A- 5 646 058
- WONG H -S P ET AL: "SELF-ALIGNED (TOP AND BOTTOM) DOUBLE-GATE MOSFET WITH A 25 NM THICK SILICON CHANNEL" INTERNATIONAL ELECTRON DEVICES MEETING,US,NEW YORK, NY: IEEE, 7. Dezember 1997 (1997-12-07), Seiten 427-430, XP000855829 ISBN: 0-7803-4101-5 in der Anmeldung erwähnt
- COLINGE J P ET AL: "SILICON-ON-INSULATOR GATE-ALL-AROUND DEVICE" INTERNATIONAL ELECTRON DEVICES MEETING,US,NEW YORK, IEEE, Bd. -, 9. Dezember 1990 (1990-12-09), Seiten 595-598, XP000279606 in der Anmeldung erwähnt

## Beschreibung

Die Erfindung betrifft ein Verfahren zur Herstellung eines Doppel-Gate-MOSFET-Transistors gemäß Patentanspruch 1 und einen Doppel-Gate-MOSFET-Transistor gemäß Patentanspruch 15.

Die voranschreitende Verkleinerung von Bulk-MOS-Transistoren wird durch die bekannten Kurzkanaleffekte in absehbarer Zeit an ihre Grenze stoßen. Das Prinzip des MOS-Transistors kann aber darüberhinaus noch weiter bis hinab zu Kanallängen von 10 nm oder sogar darunter genutzt werden. Voraussetzung ist ein weitestgehender Durchgriff des Gatepotentials durch das gesamte Kanalgebiet, was am besten bei sogenannten Doppel-Gate-MOSFETs bei sehr dünnem Si-Gebiet erreicht wird, wie in der Veröffentlichung von F.G. Pikus et al. in Appl. Phys. Lett. 71, 3661 (1997) gezeigt wurde.

Die Realisierung derartiger Transistoren konnte bisher nur im Labormaßstab erfolgen. So haben J. P. Colinge et al. in IEDM 90-595 ein Verfahren vorgeschlagen, bei welchem auf einem SOI-Substrat das Oxid im Bereich unter dem Transistorkanal naßchemisch entfernt und dieser Raum später mit dem Poly-Silizium des Rückseiten-Gates aufgefüllt wird. Dieses Verfahren hat jedoch den Nachteil, daß diese Ätzung nicht auf einen kleinen Bereich beschränkt werden kann und darüberhinaus keine Selbstjustierung mit dem Oberseiten-Gate besteht, was die elektrischen Eigenschaften verschlechtert.

Weiterhin haben H.-S. P. Wong et al. in IEDM 97-427 einen Prozeß vorgeschlagen, bei dem das dünne Silizium-Kanalgebiet durch epitaktisches Wachstum durch einen entsprechend dünnen Tunnel hindurch erzeugt wird. Dieser Prozeß erscheint jedoch technologisch äußerst anspruchsvoll.

In der US-A-5 646 058 ist ein Doppel-Gate-MOSFET-Transistor und ein Verfahren zu seiner Herstellung beschrieben. Dieser Transistor weist ein stegförmiges Kanalgebiet auf, welches zwischen einem Source- und einem Drainbereich angeordnet und an seinen beiden horizontalen Seiten von einer Gateelektrode und einem dazwischenliegenden Gateoxid bedeckt ist.

In der für den Vorrichtungsanspruch gattungsbildenden DE 198 03 479 A1 und dem darin in den Figuren 49-51 offenbarten Stand der Technik sind Dünnfilmtransistoren beschrieben, die oberhalb eines Substrats und einer Isolationsschicht geformt sind und in denen zumindest ein als Steg zwischen einem Source- und einem Drainbereich ausgebildeter Kanal von einem Gatebereich und dazwischen liegenden Gateoxidschichten vollständig eingebettet ist.

Der vorliegenden Erfindung liegt dementsprechend die Aufgabe zugrunde, einen Doppel-Gate-MOSFET-Transistor und ein Verfahren zu seiner Herstellung anzugeben, welches einerseits eine möglichst genaue Ausrichtung der Ober- und Unterseiten-Gates zueinander erbringt und andererseits technologisch nicht zu aufwendig und schwierig ist.

Diese Aufgabe wird mit einem Verfahren nach dem Patentanspruch 1 und einem Doppel-Gate-MOSFET-Transistor nach dem Patentanspruch 15 gelöst.

Das erfindungsgemäße Verfahren weist die folgenden Verfahrensschritte auf:
a. Bereitstellen eines Substrats, insbesondere eines Siliziumsubstrats, mit einer darauf aufgebrachten ersten Isolationsschicht, insbesondere einer Oxidschicht, einer auf die erste Isolationsschicht aufgebrachten ersten platzhaltenden Schicht und einer auf der ersten platzhaltenden Schicht aufgebrachten Halbleiterschicht, insbesondere einer Siliziumschicht;
b.Entfernen der Halbleiterschicht bis auf eine als Kanal des MOSFET vorgesehene Halbleiterschichtstruktur;
c. Abscheiden einer zweiten platzhaltenden Schicht auf der Halbleiterschichtstruktur und der ersten platzhaltenden Schicht und Strukturieren der platzhaltenden Schichten derart, daß die Halbleiterschichtstruktur im wesentlichen vollständig in den platzhaltenden Schichten eingebettet wird;
d. Abscheiden einer zweiten Isolationsschicht, insbesondere einer Oxidschicht, auf der Struktur der platzhaltenden Schichten;
e. vertikales Ätzen von zwei Vertiefungen, die entlang einer Richtung angeordnet sind, die derart dimensioniert sind, daß die Halbleiterschichtstruktur sich vollständig zwischen ihnen befindet, wobei in den Vertiefungen die zweite Isolationsschicht, die erste und die zweite platzhaltende Schicht und jeweils beidseitig ein Randabschnitt der Halbleiterschichtstruktur jeweils vollständig durchgeätzt werden;
f. Auffüllen der Vertiefungen mit elektrisch leitfähigem Material;
g. selektives Entfernen der platzhaltenden Schichten durch ein in die zweite Isolationsschicht geformtes Kontaktloch;
h. Aufbringen von dritten Isolationsschichten, insbesondere Oxidschichten, an den Innenwänden des Bereiches der entfernten platzhaltenden Schichten und auf den Oberflächen der Halbleiterschichtstruktur;
i. Einbringen eines elektrisch leitfähigen Materials in den Bereich der entfernten platzhaltenden Schichten.

Demnach besteht das Grundprinzip des erfindungsgemäßen Herstellungsprozesses darin, daß das Halbleitermaterial des zu bildenden Transistorkanals in ein Platzhaltermaterial eingebettet wird, welches im Verlaufe des Prozesses selektiv herausgeätzt und durch das elektrisch leitfähige Gate-Elektrodenmaterial ersetzt wird. Die Kanallänge wird durch einen Ätzschritt definiert, durch den die Halbleiterschicht, also der Kanalbereich, und das Platzhaltermaterial mit ein- und derselben Maske geätzt wird.

Ein erfindungsgemäßer Doppel-Gate-MOSFET-Transistor weist ein Substrat, insbesondere ein Siliziumsubstrat, eine darauf aufgebrachte erste Isolationsschicht, insbesondere eine Oxidschicht, eine Halbleiterschichtstruktur, die an ihren horizontalen Oberflächen vollständig von einer auf die erste Isolationsschicht aufgebrachten Gate-Elektrode umgeben und in dieser eingebettet ist, auf der ersten Isolationsschicht aufgebrachte Source- und Drainbereiche, die an gegenüberliegenden Seiten der Halbleiterschichtstruktur und der Gate-Elektrode angeordnet sind, wobei sie mit den vertikalen Oberflächen der Halbleiterschichtstruktur kontaktiert sind, eine die Struktur abdeckende zweite Isolationsschicht, insbesondere eine Oxidschicht, mit mindestens einem Kontaktloch in einem lateralen Abstand von der Halbleiterschichtstruktur für die Kontaktierung der Gate-Elektrode, und dritte Isolationsschichten zwischen der Gate-Elektrode und der Halbleiterschichtstruktur und den Source- und Drainbereichen auf.

Weitere vorteilhafte Ausgestaltungen der Erfindung sind in den Unteransprüchen angegeben.

Im folgenden wird der Herstellungsprozeß anhand eines bevorzugten Ausführungsbeispiels in Verbindung mit den Figuren näher erläutert. Es zeigen:
- Figur 1: eine schematische Darstellung der geometrischen Verhältnisse der während des Herstellungsprozesses zu prozessierenden Bereiche in einer Draufsicht;
- Figur 2: eine Querschnittsansicht entlang einer Linie A-A nach dem Aufbringen der für den Transistorkanal vorgesehenen Siliziumschicht;
- Figur 3: eine Querschnittsansicht entlang einer Linie A-A nach dem Strukturieren der Siliziumschicht und dem Aufbringen der zweiten Nitridschicht;
- Figur 4: eine Querschnittsansicht entlang einer Linie A-A nach dem Aufbringen der zweiten Oxidschicht und dem Ätzen eines Kontaktlochs;
- Figur 5: eine Querschnittsansicht entlang einer Linie B-B des Doppel-Gate-MOSFET.

Im folgenden wird der Prozeß zur Herstellung eines Doppel-Gate-MOSFET im einzelnen erläutert.

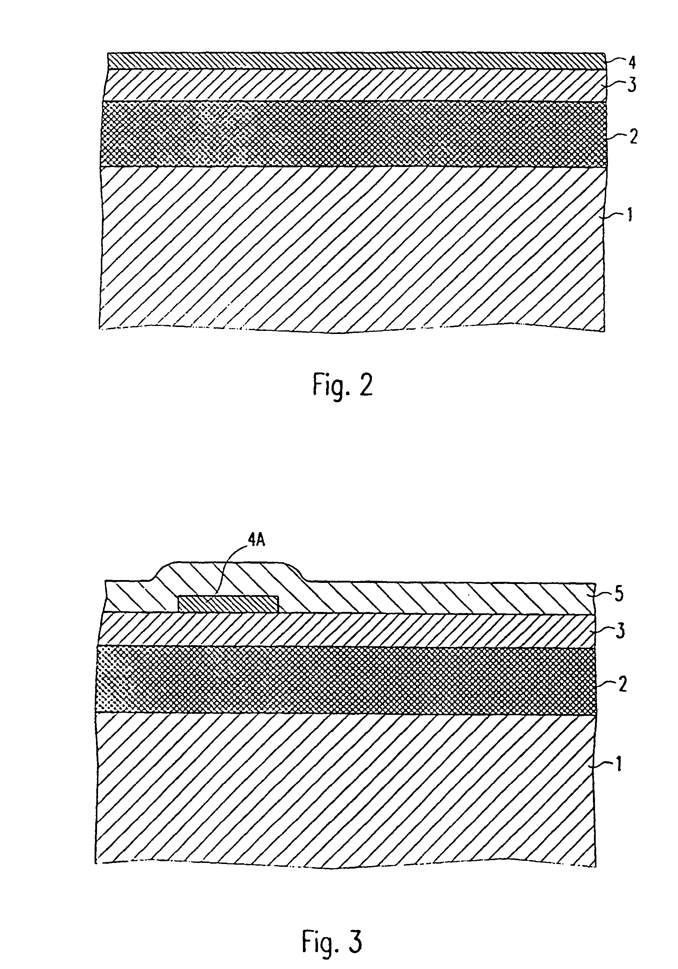

Gemäß Fig.2 besteht ein sogenanntes SOI-(silicon on insulator)Ausgangssubstrat aus einem Substrat 1 wie einem Si-Wafer, auf den nachfolgend eine erste Oxidschicht 2, eine erste platzhaltende Schicht 3 aus Siliziumnitrid (SiN) und eine Halbleiterschicht 4, im vorliegenden Fall eine Siliziumschicht aufgebracht sind. Ein solches Ausgangssubstrat kann beispielsweise durch Waferbonding hergestellt werden, indem getrennt voneinander auf einen ersten Siliziumwafer eine Oxidschicht aufgewachsen wird und auf einen zweiten Siliziumwafer eine Nitridschicht aufgewachsen wird und die beiden Siliziumwafer an der Oxid- bzw. der Nitridschicht durch das an sich im Stand der Technik bekannte Waferbonding-Verfahren aneinander fixiert werden. Anschließend muß bei diesem Prozeß der zweite Siliziumwafer durch Polieren und/oder Ätzen auf die gewünschte Dicke gebracht werden. Alternativ zu diesem Herstellungsprozeß kann die in Fig.2 gezeigte Struktur auch durch aufeinanderfolgendes Abscheiden des gezeigten Schichtaufbaus und durch anschließendes Rekristallisieren, beispielsweise Laser-Rekristallisieren des polykristallin aufgewachsenen Siliziums erhalten werden. Es ist aber theoretisch auch denkbar, die Halbleiterschicht 4 im polykristallinen Zustand mit geringer Kristallitgröße oder sogar im amorphen Zustand zu belassen. Zwar ist die Beweglichkeit in diesem Zustand relativ stark eingeschränkt. Das geringe Volumen des Kanalgebiets und der vollständige Durchgriff des Gatepotentials läßt jedoch auch dann eine brauchbare Leistung des Bauelements erwarten. Es könnte dann bei der Herstellung auf das aufwendige Rekristallisationsverfahren verzichtet werden.

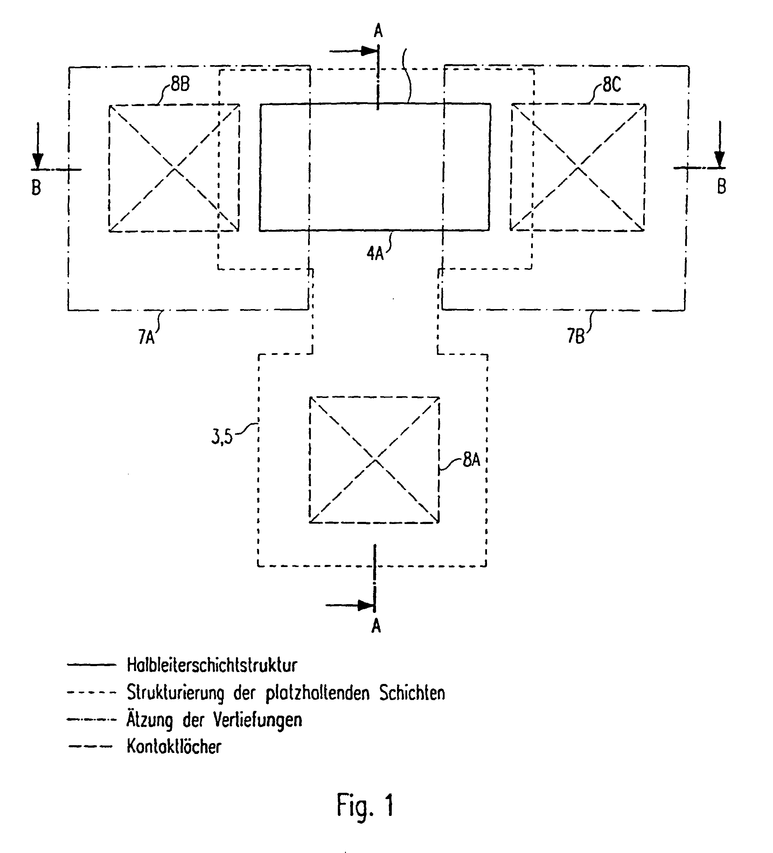

Anschließend wird die Siliziumschicht durch ein geeignetes Verfahren strukturiert, so daß eine Halbleiterschichtstruktur 4A, im vorliegenden Fall ein rechteckförmiger Bereich, davon stehenbleibt, wie er in Fig.1 durch die durchgezogene Linie gezeigt ist.

Dieser rechteckförmige Bereich wird anschließend von einer zweiten platzhaltenden Schicht 5 aus SiN überwachsen, so daß er von dem SiN-Material vollständig umschlossen ist, wie in Fig.3 dargestellt ist. Wie weiter unten ersichtlich werden wird, dient das SiN-Material als Platzhaltermaterial für die an dessen Stelle einzusetzende Gateelektrode.

Anschließend werden die platzhaltenden Schichten 3 und 5 durch ein geeignetes Verfahren derart strukturiert, daß ein Bereich davon stehenbleibt, wie er in Fig.1 durch die gestrichelte Linie gezeigt ist. Dieser Bereich weist im wesentlichen zwei rechteckförmige Abschnitte auf, die durch einen Steg miteinander verbunden sind. Der in der Darstellung der Fig.1 obere rechteckförmige Bereich enthält die eingebettete Halbleiterschichtstruktur. Außerhalb des Bereichs der gestrichelten Linie in Fig.1 liegt die erste Oxidschicht 2 an der Oberfläche.

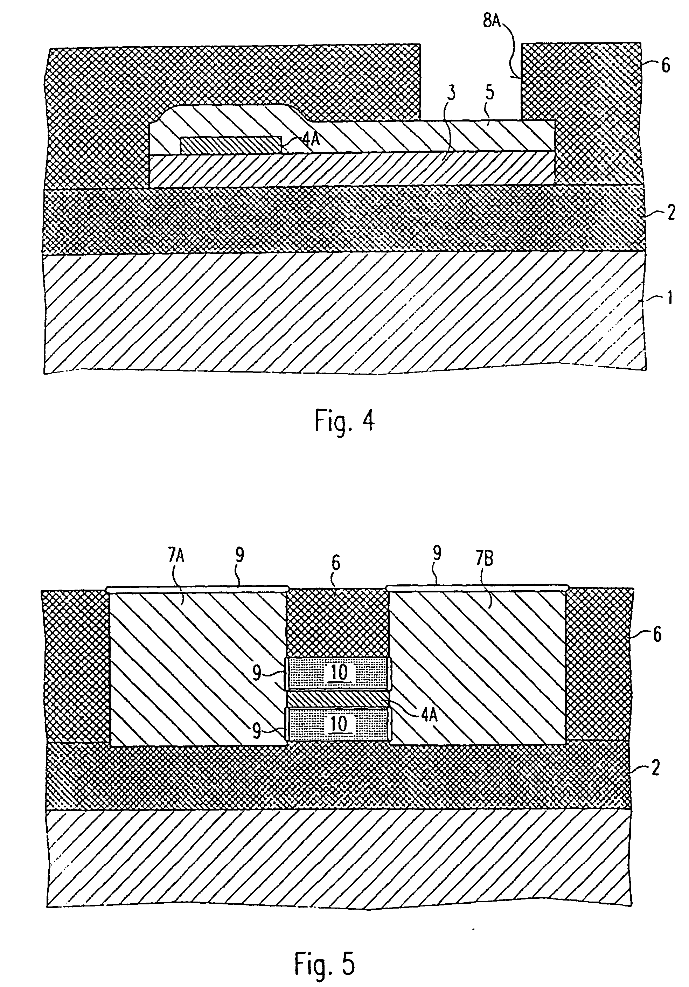

Auf diese Struktur wird nun eine zweite Oxidschicht 6 abgeschieden und anschließend deren Oberfläche planarisiert, wie in Fig.4 zu sehen ist. Die Planarisierung kann beispielsweise durch chemisch-mechanisches Polieren erfolgen.

Anschließend werden in den in Fig.1 strichpunktierten Bereichen vertikale Vertiefungen 7A, 7B in die Struktur geätzt, wobei jeweils in den Vertiefungen 7A, 7B die erste und die zweite platzhaltende Schicht 3, 5 und jeweils beidseitig ein Randabschnitt der Halbleiterschichtstruktur 4A jeweils vollständig durchgeätzt werden, wie in Fig.5 zu sehen ist. Die strichpunktierten, zu ätzenden Bereiche liegen sich in der Draufsicht der Fig.1 auf den kurzen Seiten des rechteckförmigen Siliziumbereichs 4A gegenüber, wobei beidseits ein geringfügiger Überlapp mit dem rechteckförmigen Siliziumbereich besteht. Bei der Ätzung wird also der rechteckförmige Siliziumbereich 4A in beiden Vertiefungen 7A, 7B angeätzt. In den geätzten Vertiefungen liegen also die jeweiligen Stirnseiten des Siliziumbereichs 4A an jeweiligen Innenwänden frei. Wie ferner in Fig.5 zu erkennen ist, werden in die Tiefe die Nitridschichten 3, 5 und die Siliziumschicht 4 vollständig durchgeätzt, so daß die Oxidschicht 2 an der Oberfläche leicht angeätzt wird. Für den Ätzvorgang kann die Oxidschicht 2 auch als Ätzstoppschicht verwendet werden.

In den Vertiefungen 7A, 7B werden anschließend durch Auffüllen mit elektrisch leitfähigem Material die Source- und Drain-Bereiche hergestellt. Dieses Material kann beispielsweise hochdotiertes Poly-Silizium, ein Metall oder ein Metallsilizid sein. Die Abscheidung des Materials muß langsam erfolgen, so daß die Vertiefungen 7A, 7B nennenswert gefüllt werden, bevor die Öffnung zuwächst. Die Source- und Drain-Bereiche stehen nach diesem Verfahrensschritt somit auf beiden Seiten mit dem Siliziumbereich 4A in Kontakt. Anschließend erfolgt auch hier eine Planarisierung der Oberfläche, die beispielsweise durch Rückätzen oder chemisch-mechanisches Polieren durchgeführt werden kann.

Dann wird ein erstes Kontaktloch 8A im Bereich des unteren rechteckförmigen Abschnitts der Nitridschichten (s. Fig.1) in die Oxidschicht 6 geformt. Das Ergebnis ist in Fig.4 in einer Querschnittsansicht entlang der Linie A-A der Fig.1 gezeigt. Anschließend werden durch dieses Kontaktloch 8A die platzhaltenden Siliziumnitridschichten beispielsweise naßchemisch selektiv herausgeätzt. Als Ergebnis wird eine Struktur erhalten, in der ein freischwebender, als Kanalbereich des herzustellenden Transistors vorgesehener Si-Steg (Bezugszeichen 4A) nur an seinen Stirnseiten durch die Source- und Drain-Bereiche gehalten wird, wie gezeigt in Fig.5.

Anschließend werden Isolationsschichten 9 beispielsweise durch thermisches Oxidieren geformt. Dabei bildet sich ein relativ dünnes Gateoxid an dem Si-Steg 4A und im Falle der Verwendung von dotiertem polykristallinem Silizium für die Source- und Drain-Bereiche bildet sich aufgrund der Zunahme der Oxidwachstumsgeschwindigkeit mit dem Dotierungsgrad gleichzeitig ein dickeres thermisches Oxid an den Source- und Drain-Bereichen, wie in der Fig.5 zu erkennen ist. Auch an der Oberfläche der Source- und Drain-Bereiche wird somit ein relativ dickes thermisches Oxid gebildet.

Dann wird in den freigeätzten Bereichen, in denen sich vordem die platzhaltenden Siliziumnitridschichten 3, 5 befunden hatten, die Gateelektrode 10 gebildet. Dies erfolgt vorzugsweise durch eine CVD-Abscheidung (chemische Dampfphasenabscheidung) von hochdotiertem Poly-Silizium, gefolgt von einer Planarisierung der Oberfläche der Struktur. Die Dotierung erfolgt dabei in-situ, also während der Abscheidung, und das Dotiermaterial ist beispielsweise Phosphor, wodurch der Halbleiter n-leitend gemacht wird. Als Gateelektrode kann jedoch auch ein Metall oder ein Metallsilizid abgeschieden werden. Anschließend erfolgt wieder ein Planarisieren der Oberfläche durch Rückätzen oder chemisch-mechanisches Polieren.

Dadurch daß die Ätzung der Vertiefungen 7A, 7B mit ein- und derselben Maske durchgeführt wird, wird somit gleichzeitig die Kanallänge und die Position der Gateelektroden definiert, wodurch die Gateelektroden sehr genau zueinander ausgerichtet werden.

In dem in Fig.5 gezeigten Zustand des Bauelements sind die Source- und Drain-Bereiche noch nicht mit Metallkontakten versehen. Demnach werden schließlich noch in die Oxidschichten der Source- und Drain-Bereiche Kontaktlöcher 8B, C geformt, wie durch die punktierten Linien in der Fig.1 gezeigt. Diese Kontaktlöcher 8B, C werden schließlich metallisiert, wodurch Source- und Drain-Kontakte hergestellt sind.

## Patentansprüche

1. Verfahren zur Herstellung eines Doppel-Gate-MOSFET-Transistors,
**gekennzeichnet durch** die Verfahrensschritte
a. Bereitstellen eines Substrats (1), insbesondere eines Siliziumsubstrats, mit einer darauf aufgebrachten ersten Isolationsschicht (2), insbesondere einer Oxidschicht, einer auf die erste Isolationsschicht (2) aufgebrachten ersten platzhaltenden Schicht (3) und einer auf der ersten platzhaltenden Schicht (3) aufgebrachten Halbleiterschicht (4), insbesondere einer Siliziumschicht;
b. Entfernen der Halbleiterschicht (4) bis auf eine als Kanal des MOSFET vorgesehene Halbleiterschichtstruktur (4A);
c. Abscheiden einer zweiten platzhaltenden Schicht (5) auf der Halbleiterschichtstruktur (4A) und der ersten platzhaltenden Schicht (3) und Strukturieren der platzhaltenden Schichten (3, 5) derart, daß die Halbleiterschichtstruktur (4A) im wesentlichen vollständig in den platzhaltenden Schichten (3, 5) eingebettet wird;
d. Abscheiden einer zweiten Isolationsschicht (6), insbesondere einer Oxidschicht, auf der Struktur der platzhaltenden Schichten (3, 5);
e. vertikales Ätzen von zwei Vertiefungen (7A, 7B), die entlang einer Richtung angeordnet sind, die derart dimensioniert sind, daß die Halbleiterschichtstruktur (4A) sich vollständig zwischen ihnen befindet, wobei in den Vertiefungen (7A, 7B) die zweite Isolationsschicht (6), die erste und die zweite platzhaltende Schicht (3, 5) und jeweils beidseitig ein Randabschnitt der Halbleiterschichtstruktur (4A) jeweils vollständig durchgeätzt werden;
f. Auffüllen der Vertiefungen (7A, 7B) mit elektrisch leitfähigem Material;
g. selektives Entfernen der platzhaltenden Schichten (3, 5) **durch** ein in die zweite Isolationsschicht (6) geformtes Kontaktloch (8A);
h. Aufbringen von dritten Isolationsschichten (9), insbesondere Oxidschichten, an den Innenwänden des Bereiches der entfernten platzhaltenden Schichten (3, 5) und auf den Oberflächen der Halbleiterschichtstruktur (4A);
i. Einbringen eines elektrisch leitfähigen Materials in den Bereich der entfernten platzhaltenden Schichten (3, 5).

2. Verfahren nach Anspruch 1,
**dadurch gekennzeichnet, daß**
- der Verfahrensschritt a. derart durchgeführt wird, daß
- auf das Substrat (1) nacheinander die erste Isolationsschicht (2), die erste platzhaltende Schicht (3) und die Halbleiterschicht (4) aufgebracht werden.

3. Verfahren nach Anspruch 2,
**dadurch gekennzeichnet, daß**
- die Halbleiterschicht (4) nach dem Aufbringen rekristallisiert wird, insbesondere indem sie mit einem Laserstrahl bestrahlt wird.

4. Verfahren nach Anspruch 1,
**dadurch gekennzeichnet, daß**
- der Verfahrensschritt a. derart durchgeführt wird, daß
- auf ein erstes Halbleitersubstrat die erste Isolationsschicht (2) aufgebracht wird und auf ein zweites Halbleitersubstrat die erste platzhaltende Schicht (3) aufgebracht wird und,
- die beiden Halbleitersubstrate insbesondere mittels Waferbonding an der Isolationsschicht (2) und der ersten platzhaltenden Schicht (3) miteinander verbunden werden,
- das zweite Halbleitersubstrat durch Reduzierung seiner Dicke in die gewünschte Halbleiterschicht (4) umgewandelt wird.

5. Verfahren nach Anspruch 1,
**dadurch gekennzeichnet, daß**
- die platzhaltenden Schichten (3, 5) in den Verfahrensschritten a. und c. durch Siliziumnitrid gebildet werden.

6. Verfahren nach Anspruch 1,
**dadurch gekennzeichnet, daß**
- die zweite Isolationsschicht (6) nach ihrer Abscheidung planarisiert wird.

7. Verfahren nach Anspruch 1,
**dadurch gekennzeichnet, daß**
- das selektive Entfernen der platzhaltenden Schichten (3, 5) im Verfahrensschritt f. durch eine in die zweite Isolationsschicht (6) geformte Öffnung (8A) durchgeführt wird.

8. Verfahren nach Anspruch 1,
**dadurch gekennzeichnet, daß**
- das elektrisch leitfähige Material im Verfahrensschritt e. durch dotiertes polykristallines Silizium, ein Metall oder ein Silizid gebildet werden.

9. Verfahren nach Anspruch 8,
**dadurch gekennzeichnet, daß**
- das dotierte polykristalline Silizium durch chemische Dampfphasenabscheidung gebildet wird und die Dotierung während der Abscheidung (in-situ), insbesondere durch Arsen-Atome, vorgenommen wird.

10. Verfahren nach Anspruch 1,
**dadurch gekennzeichnet, daß**
- im Verfahrensschritt f. die platzhaltenden Schichten (3, 5) durch einen selektiv wirkenden naßchemischen Ätzschritt entfernt werden.

11. Verfahren nach Anspruch 1,
**dadurch gekennzeichnet, daß**
- im Verfahrensschritt g. das Aufbringen der Isolationsschichten (9) durch thermische Oxidation erfolgt.

12. Verfahren nach Anspruch 11,
**dadurch gekennzeichnet, daß**
- auf der Oberfläche der Halbleiterschichtstruktur (4A) ein relativ dünnes Oxid und an den Innenwänden des Bereiches der entfernten platzhaltenden Schichten (3, 5) ein relativ dickes Oxid erzeugt wird.

13. Verfahren nach Anspruch 1,
**dadurch gekennzeichnet, daß**
- im Verfahrensschritt i. das elektrisch leitfähige Material durch dotiertes polykristallines Silizium, ein Metall oder ein Silizid gebildet wird.

14. Verfahren nach Anspruch 13,
**dadurch gekennzeichnet, daß**
- das dotierte polykristalline Silizium durch chemische Dampfphasenabscheidung gebildet wird und die Dotierung, insbesondere durch Phosphor-Atome, während der Abscheidung (in-situ) vorgenommen wird.

15. Doppel-Gate-MOSFET-Transistor, mit
- einem Substrat (1), insbesondere einem Siliziumsubstrat,
- einer darauf aufgebrachten ersten Isolationsschicht (2), insbesondere einer Oxidschicht,
- einer Halbleiterschichtstruktur (4A), die an ihren horizontalen Oberflächen vollständig von einer auf die erste Isolationsschicht (2) aufgebrachten Gate-Elektrode (10) umgeben und in dieser eingebettet ist,
- auf der ersten Isolationsschicht (2) aufgebrachte Source-(7A) und Drainbereiche (7B), die an gegenüberliegenden Seiten der Halbleiterschichtstruktur (4A) und der Gate-Elektrode (10) angeordnet sind, wobei sie mit den vertikalen Oberflächen der Halbleiterschichtstruktur (4A) kontaktiert sind,
- dritten Isolationsschichten (9) zwischen der Gate-Elektrode (10) einerseits und der Halbleiterschichtstruktur (4A) und den Source- (7A) und Drainbereichen (7B) anderseits
**dadurch gekennzeichnet, dass**
- auf die erste Isolationsschicht (2) und die Gate-Elektrode (10) eine zweite Isolationsschicht (6), insbesondere einer Oxidschicht, aufgebracht ist, in welche
- im Bereich der Gate-Elektrode (10) in einem lateralen Abstand von der Halbleiterschichtstruktur (4A) ein Kontaktloch (8A) für die Kontaktierung der Gate-Elektrode (10) geformt ist.

16. Doppel-Gate-MOSFET-Transistor nach Anspruch 15,
**dadurch gekennzeichnet, daß**
- die Gate-Elektrode (10) und/oder die Source- (7A) und Drainbereiche (7B) durch dotiertes polykristallines Silizium, ein Metall oder ein Silizid gebildet werden.

## Claims

1. Method for fabricating a dual-gate MOSFET transistor,
**characterized by** the method steps of
a. providing a substrate (1), in particular a silicon substrate, with a first insulation layer (2), in particular an oxide layer, applied thereto, a first spacer layer (3) applied to the first insulation layer (2), and a semiconductor layer (4), in particular a silicon layer, applied on the first spacer layer (3);
b. removing the semiconductor layer (4) except for a semiconductor layer structure (4A) provided as the channel of the MOSFET;
c. depositing a second spacer layer (5) on the semiconductor layer structure (4A) and the first spacer layer (3) and patterning the spacer layers (3, 5) in such a way that the semiconductor layer structure (4A) is essentially completely embedded in the spacer layers (3, 5);
d. depositing a second insulation layer (6), in particular an oxide layer, on the structure of the spacer layers (3, 5);
e. vertically etching two depressions (7A, 7B) arranged along one direction, which are dimensioned in such a way that the semiconductor layer structure (4A) is situated completely between them, in the depressions (7A, 7B) the second insulation layer (6), the first and second spacer layers (3, 5) and, in each case on both sides, an edge section of the semiconductor layer structure (4A) being etched through completely in each case;
f. filling the depressions (7A, 7B) with electrically conductive material;
g. selectively removing the spacer layers (3, 5) through a contact hole (8A) made in the second insulation layer (6);
h. applying third insulation layers (9), in particular oxide layers, on the inner walls of the region of the removed spacer layers (3, 5) and on the surfaces of the semiconductor layer structure (4A);
i. introducing an electrically conductive material into the region of the removed spacer layers (3, 5).

2. Method according to Claim 1,
**characterized in that**
- method step a. is carried out in such a way that
- the first insulation layer (2), the first spacer layer (3) and the semiconductor layer (4) are applied to the substrate (1) one after the other.

3. Method according to Claim 2,
**characterized in that**
- the semiconductor layer (4) is recrystallized after being applied, in particular by being irradiated with a laser beam.

4. Method according to Claim 1,
**characterized in that**
- method step a. is carried out in such a way that
- the first insulation layer (2) is applied to a first semiconductor substrate and the first spacer layer (3) is applied to a second semiconductor substrate, and
- the two semiconductor substrates are connected to one another by means of wafer bonding, in particular, at the insulation layer (2) and the first spacer layer (3),
- the second semiconductor substrate is converted into the desired semiconductor layer (4) by its thickness being reduced.

5. Method according to Claim 1,
**characterized in that**
- the spacer layers (3, 5) are formed by silicon nitride in method steps a. and c.

6. Method according to Claim 1,
**characterized in that**
- the second insulation layer (6) is planarized after being deposited.

7. Method according to Claim 1,
**characterized in that**
- the selective removal of the spacer layers (3, 5) is carried out in method step f. through an opening (8A) made in the second insulation layer (6).

8. Method according to Claim 1,
**characterized in that**
- the electrically conductive material is formed by doped polycrystalline silicon, a metal or a silicide in method step e.

9. Method according to Claim 8,
**characterized in that**
- the doped polycrystalline silicon is formed by chemical vapour phase deposition and the doping is performed during the deposition (in situ), in particular by means of arsenic atoms.

10. Method according to Claim 1,
**characterized in that**
- in method step f., the spacer layers (3, 5) are removed by a selectively acting, wet-chemical etching step.

11. Method according to Claim 1,
**characterized in that**
- in method step g., the insulation layers (9) are applied by thermal oxidation.

12. Method according to Claim 11,
**characterized in that**
- a relatively thin oxide is produced on the surface of the semiconductor layer structure (4A) and a relatively thick oxide is produced on the inner walls of the region of the removed spacer layers (3, 5).

13. Method according to Claim 1,
**characterized in that**
- in method step i., the electrically conductive material is formed by doped polycrystalline silicon, a metal or a silicide.

14. Method according to Claim 13,
**characterized in that**
- the doped polycrystalline silicon is formed by chemical vapour phase deposition and the doping, in particular by means of phosphorous atoms, is performed during the deposition (in situ).

15. Dual-gate MOSFET transistor, having
- a substrate (1), in particular a silicon substrate,
- a first insulation layer (2), in particular an oxide layer, applied thereto,
- a semiconductor layer structure (4A), which, at its horizontal surfaces, is completely surrounded by a gate electrode (10) applied to the first insulation layer (2) and is embedded in the said gate electrode,
- Source (7A) and drain regions (7B), which are applied on the first insulation layer (2) and are arranged on opposite sides of the semiconductor layer structure (4A) and of the gate electrode (10), and they are contact-connected to the vertical surfaces of the semiconductor layer structure (4A),
- third insulation layers (9) between the gate electrode (10) on the one hand and the semiconductor layer structure (4A) and the source (7A) and drain regions (7B) on the other hand,
**characterized in that**
- a second insulation layer (6), in particular an oxide layer, is applied to the first insulation layer (2) and the gate electrode (10), in which second insulation layer
- a contact hole (8A) for making contact with the gate electrode (10) is made in the region of the gate electrode (10) at a lateral distance from the semiconductor layer structure (4A).

16. Dual-gate MOSFET transistor according to Claim 15,
**characterized in that**
- the gate electrode (10) and/or the source (7A) and drain regions (7B) are formed by doped polycrystalline silicon, a metal or a silicide.

## Revendications

1. Procédé de production d'un transistor MOSFET à grille double,
**caractérisé par** les stades de procédé
a. on se procure un substrat (1), notamment un substrat en silicium sur lequel est déposée une première couche (2) isolante, notamment une couche d'oxyde, première couche (2) isolante sur laquelle est déposée une première couche (3) intercalaire, première couche (3) intercalaire sur laquelle est déposée une couche (4) semi-conductrice, notamment une couche en silicium;
b. on élimine la couche (4) semi-conductrice à l'exception d'une structure (4A) de couche semi-conductrice prévue comme canal du MOSFET;
c. on dépose une deuxième couche (5) intercalaire sur la structure (4A) de couche semi-conductrice et sur la première couche (3) intercalaire et on structure les couches (3, 5) intercalaires de façon à ce que la structure (4A) de couche semi-conductrice soit sensiblement entièrement incorporée dans les couches (3, 5) intercafaires;
d. on dépose une deuxième couche (6) isolante notamment une couche d'oxyde, sur la structure des couches (3, 5) intercalaires;
e. on ménage par attaque verticale deux cavités (7A, 7B) qui sont disposées suivant une direction et qui ont des dimensions telles que la structure (4A) de couche semi-conductrice se trouve entièrement entre elles, la deuxième couche isolante, la première et la deuxième couche (3, 5) intercalaire et respectivement des deux côtés une partie de bord de la structure (4A) de couche semi-conductrice étant respectivement attaquées entièrement dans les cavités (7A, 7B) ;
f. on remplit les cavités (7A, 7B) d'une matière conductrice de l'électricité;
g. on élimine sélectivement les couches (3, 5) intercalaires par un trou (8A) de contact formé dans la deuxième couche (6) isolante;
h. on dépose des troisièmes couches (9) isolantes, notamment des couches d'oxyde, sur les parois intérieures de la zone des couches (3, 5) intercalaires éliminées et sur les surfaces de la structure (4A) de couche semi-conductrice;
i. on introduit une matière conductrice d'électricité dans la zone des couches (3, 5) intercalaires éliminées.

2. Procédé suivant la revendication 1,
**caractérisé en ce que**
- on effectue le stade a du procédé,
- de façon à déposer sur le substrat (1) successivement la première couche (2) isolante, la première couche (3) intercalaire et la couche (4) semi-conductrice.

3. Procédé suivant la revendication 2,
**caractérisé en ce que**
- on recristallise la couche (4) semi-conductrice après le dépôt, notamment en l'exposant à un faisceau laser.

4. Procédé suivant la revendication 1,
**caractérisé en ce que**
- on effectue le stade a du procédé,
- de façon à déposer sur un premier substrat semi-conducteur la première couche (2) isolante et à déposer sur un deuxième substrat semi-conducteur la première couche (3) intercalaire et,
- on relie entre eux les deux substrats semi-conducteurs, notamment au moyen d'une liaison de tranche sur la couche (2) isolante et sur la première couche (3) intercalaire,
- on transforme le deuxième substrat semi-conducteur par réduction de son épaisseur en la couche (4) semi-conductrice souhaitée.

5. Procédé suivant la revendication 1,
**caractérisé en ce que**
- on forme les couches (3, 5) intercalaires dans les stades a et c du procédé par du nitrure de silicium.

6. Procédé suivant la revendication 1,
**caractérisé en ce que**
- on rend plane la deuxième couche (6) isolante après son dépôt.

7. Procédé suivant la revendication 1,
**caractérisé en ce que**
- on effectue l'élimination sélective des couches (3, 5) intercalaires au stade f du procédé par une ouverture (8A) pratiquée dans la deuxième couche (6) isolante.

8. Procédé suivant la revendication 1,
**caractérisé en ce que**
- on forme la matière conductrice d'électricité au stade e du procédé par du silicium polycristallin dopé, par un métal ou par un siliciure.

9. Procédé suivant la revendication 8,
**caractérisé en ce que**
- on forme le silicium polycristallin dopé par dépôt chimique en phase vapeur et on effectue le dopage pendant le dépôt (in-situ) notamment par des atomes d'arsenic.

10. Procédé suivant la revendication 1,
**caractérisé en ce que**
- au stade f du procédé on élimine les couches (3, 5) intercalaires par un stade d'attaque chimique en voie humide à effet sélectif.

11. Procédé suivant la revendication 1,
**caractérisé en ce que**
- au stade g du procédé on effectue le dépôt des couches (9) isolantes par oxydation thermique.

12. Procédé suivant la revendication 1,
**caractérisé en ce que**
- on produit sur la surface de la structure (4A) de couche semi-conductrice un oxyde relativement mince et sur les parois intérieures de la zone des couches (3, 5) intercalaires éliminées un oxyde relativement épais.

13. Procédé suivant la revendication 1,
**caractérisé en ce que**
- au stade i du procédé on forme la matière conductrice d'électricité par du silicium polycristallin dopé, par un métal ou par un siliciure.

14. Procédé suivant la revendication 13,
**caractérisé en ce que**
- on forme le silicium polycristallin dopé par dépôt chimique en phase vapeur et on effectue le dopage notamment par des atomes de phosphore pendant le dépôt ( in-situ).

15. Transistor MOSFET à grille double comprenant,
- un substrat (1) notamment un substrat en silicium,
- une première couche (2) isolante, notamment une couche d'oxyde déposée dessus,
- une structure (4A) de couche semi-conductrice, qui sur ses surfaces horizontales est entourée entièrement d'une électrode (10) de grille déposée sur la première couche (2) isolante et est incorporée dans cette électrode,
- des zones de source (7A) et de drain (7B) qui sont déposées sur la première couche (2) isolante et qui sont disposées sur des faces opposées de la structure (4A) de couche semi-conductrice et de l'électrode (10) de grille en étant mises en contact avec les surfaces verticales de la structure (4A) de couche semi-conductrice,
- des troisièmes couches (9) isolantes entre l'électrode (10) de grille d'une part et la structure (4A) semi-conductrice et les zones de source (7A) et de drain (7B) d'autre part,
**caractérisé en ce que**
- il est déposé sur la première couche (2) isolante et l'électrode (10) de grille une deuxième couche (6) isolante, notamment une couche d'oxyde dans laquelle,
- dans la zone de l'électrode (10) de grille il est formé à une distance latérale de la structure (4A) de couche semi-conductrice un trou (8A) de contact pour la mise en contact de l'électrode (10) de grille.

16. Transistor MOSFET à grille double suivant la revendication 15,
**caractérisé en ce que**
- l'électrode (10) de grille et/ou les zones de source (7A) et de drain (7B) sont formées par du silicium polycristallin dopé, par un métal ou par un siliciure.
